# EUROPEAN PATENT APPLICATION

(11) **EP 4 773 767 A1**
(43) Date of publication of application: **08.07.2026**
(21) Application number: 24858285.0
(22) Date of filing: 12.08.2024
(51) Int. Cl.: H10K 59/12, G09G 3/22

(54) **ARRAY SUBSTRATE AND DISPLAY PANEL COMPRISING SAME**

(30) Priority: 30.08.2023 CN 202311099965
(71) Applicant: HKC Corporation Limited, Shenzhen, Guangdong 518101 (CN)
(72) Inventor: YUAN, Xin, Shenzhen, Guangdong 518101 (CN); CHEN, Chen, Shenzhen, Guangdong 518101 (CN); ZHOU, Xiufeng, Shenzhen, Guangdong 518101 (CN); YUAN, Haijiang, Shenzhen, Guangdong 518101 (CN)
(74) Representative: De Arpe Tejero, Manuel
(86) International application number: PCT/CN2024/111495
(87) International publication number: WO 2025/044742

(57) **Abstract**

An array substrate includes: pixel units, scan signal lines and drive signal lines, and reset signal lines. The pixel units include first pixel units in and second pixel units. Some first pixel units and some second pixel units are arranged in one row and connected via one first scan signal line and one first drive signal line. Some first pixel units and some second pixel units are arranged in one column and are connected via one first reset signal line. A resistance compensation unit is connected to each signal line. At least part of a projection overlapping region of an extension line of the first scan signal line overlapping with an extension line of the first drive signal line forms a capacitance compensation unit connected to each signal line.

## Description

### CROSS REFERENCE TO RELATED APPLICATIONS

The present application claims the priority of the Chinese patent application No. 2023110999656, filed on August 30, 2023, contents of which are incorporated herein by its entireties.

### TECHNICAL FIELD

Embodiments of the present disclosure relate to the technical field of displaying, and more specifically, to an array substrate and a display panel.

### BACKGROUND

In order to achieve a high screen-to-body ratio, an under-display camera (UDC) region may be arranged in a display region of a display device in the art, and the UDC region needs to achieve dual functions of image capturing and displaying. Therefore, light transmission of the UDC region needs to be greater than that of a normal display region, so as to ensure sufficient light to enter the UDC region to meet image capturing requirements. Furthermore, pixel circuits need to be arranged for the UDC region to satisfy corresponding displaying functions.

However, in order to ensure that the light transmittance of the UDC region to be greater than that of the normal display region, a pixel density of the UDC region needs to be less than that of the normal display region, or sizes of pixel units in the UDC region need to be less than those in the normal display region. In this case, n rows of pixels located in the UDC region may provide different display effects from pixels located in the rest region.

### SUMMARY

The present disclosure provides an array substrate and a display panel, so as to solve the technical problem that n rows of pixels located in the UDC region may provide different display effects from pixels located in the rest region.

In a first aspect, the present disclosure provides an array substrate, including: a plurality of pixel units arranged in an array, a plurality of scan signal lines and a plurality of drive signal lines connecting to a plurality of rows of the plurality of pixel units, and a plurality of reset signal lines connecting a plurality of columns of the plurality of pixel units. The plurality of pixel units includes a plurality of first pixel units arranged in a first display region and a plurality of second pixel units arranged in a second display region; at least a portion of the plurality of first pixel units and at least a portion of the plurality of second pixel units are arranged in one row and connected to each other via a respective one of the plurality of first scan signal lines and a respective one of the plurality of first drive signal lines; at least part of the plurality of first pixel units and at least part of the plurality of second pixel units are arranged in one column and are connected to each other via a respective one of the plurality of first reset signal lines; a light transmittance of the first display region is greater than that of the second display region. A resistance compensation unit is connected in series to each of the respective first scan signal line, the respective first drive signal line, and the respective first reset signal line; a projection overlapping region is formed by a projection of an extension line of the respective first scan signal line overlapping with a projection of an extension line of the respective first drive signal line; at least a portion of the projection overlapping region forms a capacitance compensation unit; each of the respective first scan signal line, the respective first drive signal line, and the respective first reset signal line is connected in parallel to the capacitance compensation unit.

In some embodiments, the array substrate includes: a substrate; a semiconductor layer, disposed on a first surface of the substrate, where the semiconductor layer includes a first semiconductor layer for forming the plurality of first pixel units, a second semiconductor layer for forming the plurality of second pixel units, and semiconductor wires for forming the resistance compensation unit; a gate insulating layer, disposed at a surface of the semiconductor layer away from the substrate; a first metal layer, disposed on a surface of the gate insulating layer away from the substrate; where the first metal layer includes: first gates for forming the plurality of first pixel units; second gates for forming the plurality of second pixel units; and a first metal wire for forming a portion of the respective first scan signal line and the extension line of the respective first scan signal line and forming a portion of the respective first drive signal line and the extension line of the respective first drive signal line; an interlayer dielectric layer, disposed on the first surface of the substrate and covering the semiconductor layer and the first metal layer; a second metal layer, disposed on a surface of the interlayer dielectric layer away from the gate insulating layer and including: a first source and a first drain that are insulated and are for forming each of the plurality of first pixel units; a second source and a second drain that are insulated and are for forming each of the plurality of second pixel units; a second metal wire for forming a portion of the respective first scan signal line and the extension line of the respective first scan signal line and forming a portion of the respective first drive signal line and the extension line of the respective first drive signal line. At least a portion of a projection of the extension line of the respective first scan signal line on the substrate and at least a portion of a projection of the extension line of the respective first drive signal line on the substrate overlap with each other to serve as the capacitance compensation unit.

In some embodiments, the semiconductor wire includes a first semiconductor sub-wire and a second semiconductor sub-wire; the first metal wire includes a first metal sub-wire for forming the portion of the first scan signal line, a second metal sub-wire for forming a portion of the extension line of the first scan signal line, and a third metal sub-wire for forming a portion of the first drive signal line metal wire; the second metal wire includes a fourth metal sub-wire and a fifth metal sub-wire for forming a portion of the first scan signal line, a sixth metal sub-wire for forming a portion of the extension line of the first drive signal line, and a seventh metal sub-wire for forming a portion of the extension line of the first drive signal line; the first metal sub-wire is connected to the fourth metal sub-wire through a first contact hole penetrating the interlayer dielectric layer; the fourth metal sub-wire is connected to the first semiconductor sub-wire through a second contact hole; the first semiconductor sub-wire is connected to the fifth metal sub-wire through a third contact hole; the fifth metal sub-wire is connected to the second metal sub-wire through a fourth contact hole; the first semiconductor sub-wire serves as the resistance compensation unit on the first scan signal line; the third metal sub-wire is connected to the sixth metal sub-wire through a fifth contact hole penetrating the interlayer dielectric layer, the sixth metal sub-wire is connected to the second semiconductor sub-wire through a sixth contact hole, and the second semiconductor sub-wire is connected to the seventh metal sub-wire through a seventh contact hole; the second semiconductor sub-wire serves as the resistance compensation unit on the first drive signal line. A projection of the second metal sub-wire on the substrate at least partially overlaps with a projection of the seventh metal sub-wire on the substrate; a projection overlapping region of the projection of the second metal sub-wire and the projection of the seventh metal sub-wire serves as the capacitance compensation unit on the first scan signal line, the first drive signal line, and/or the first reset signal line.

In some embodiments, the array substrate further includes: a passivation layer, disposed on a surface of the interlayer dielectric layer away from the gate insulating layer and covering the second metal layer; a third metal layer, disposed on a surface of the passivation layer away from the interlayer dielectric layer, where at least a portion of a projection of the third metal layer on the substrate overlaps with at least a portion of the extension line of the first scan signal line and/or a projection of the extension line of the first drive signal line on the substrate; at least a portion of a projection overlapping region of the projection of the third metal layer on the substrate overlaps and the portion of the extension line of the first scan signal line and/or the projection of the extension line of the first drive signal line on the substrate serves as the capacitance compensation unit.

In some embodiments, the semiconductor wire includes a third semiconductor sub-wire and a fourth semiconductor sub-wire. The first metal wire includes: an eighth metal sub-wire for forming a portion of the first scan signal line, a ninth metal sub-wire for forming a portion of the first drive signal line, and a tenth metal sub-wire for forming a portion of the extension line of the first scan signal line. The second metal wire includes: an eleventh metal sub-wire and a twelfth metal sub-wire for forming a portion of the first scan signal line, a thirteenth metal sub-wire for forming a portion of the first drive signal line, and a fourteenth metal sub-wire and a fifteenth metal sub-wire for forming a portion of the extension line of the first drive signal line. The third metal layer includes a sixteenth metal sub-wire. The eighth metal sub-wire is connected to the eleventh metal sub-wire through an eighth contact hole penetrating the interlayer dielectric layer, the eleventh metal sub-wire is connected to the third semiconductor sub-wire through a ninth contact hole, the third semiconductor sub-wire is connected to the twelfth metal sub-wire through a tenth contact hole, the twelfth metal sub-wire is connected to the sixteenth metal sub-wire through an eleventh contact hole; the third semiconductor sub-wire serves as the resistance compensation unit on the first scan signal line. The ninth metal sub-wire is connected to the thirteenth metal sub-wire through a twelfth contact hole penetrating the interlayer dielectric layer, the thirteenth metal sub-wire is connected to the fourth semiconductor sub-wire through a thirteenth contact hole, and the fourth semiconductor sub-wire is connected to the fourth semiconductor sub-wire through a fourteenth contact hole, the fourteenth metal sub-wire is connected to the tenth metal sub-wire through a fifteenth contact hole, the fourth semiconductor sub-wire serves as the resistance compensation unit on the first drive signal line. A projection of the sixteenth metal sub-wire on the substrate at least partially overlaps with a projection of the tenth metal sub-wire on the substrate and/or a projection of the fifteenth metal sub-wire on the substrate; a projection overlapping region between the projection of the sixteenth metal sub-wire and the projection of the tenth metal sub-wire and/or the projection of the fifteenth metal sub-wire serves as the capacitance compensation unit on the first scan signal line, the first drive signal line and/or the first reset signal line.

In some embodiments, the fifteenth metal sub-wire is further connected to a preset electrical potential.

In some embodiments, a resistance value of the resistance compensation unit is correlated to sizes of the semiconductor wires and doping concentrations of the semiconductor wires; the capacitance compensation unit is correlated to an overlapping area of the projection overlapping region of the projection of the extension line of the first scan signal line and the projection of the extension line of the first drive signal line on the substrate. The resistance value of the resistance compensation unit is less than or equal to 1 KΩ; the capacitance value of the capacitance compensation unit is less than or equal to 10pF.

In some embodiments, a pixel density of the plurality of first pixel units within the first display region is the same as a pixel density of the plurality of second pixel units within the second display region, and a size of each of the plurality of first pixel units is smaller than a size of each of the plurality of second pixel units.

In some embodiments, the resistance compensation unit and the capacitance compensation unit are both disposed in the first display region; or the resistance compensation unit and the capacitance compensation unit are both disposed in the second display region; or a portion of the resistance compensation unit is disposed in the first display region, and another portion of the resistance compensation unit is disposed in the second display region; and a portion of the capacitance compensation unit is disposed in the first display region and another portion of the capacitance compensation unit is disposed in the second display region.

In a second aspect, the present disclosure provides a display panel, including: the array substrate of any of the above embodiments; and a counter substrate, disposed at a side of the array substrate.

According to the present disclosure, an array substrate and a display panel are provided. Resistance compensation units are connected in series to the first scan signal line, the first drive signal line, and the first reset signal line, such that resistance of n rows of pixels arranged in the UDC region may not be compensated. A projection of an extension line of the first scan signal line and a projection of an extension line of the first drive signal line may overlap with each other to have a projection overlapping region. At least a portion of the projection overlapping region may form a capacitance compensation unit. The first scan signal line, the first drive signal line, and the first reset signal line are all connected in parallel to the capacitance compensation unit, so as to compensate capacitance of n columns of pixels located in the UDC region. In this way, the technical problem that the n rows of pixels located in the UDC region may provide different display effects from pixels located in the rest region, may be solved.

### BRIEF DESCRIPTION OF THE DRAWINGS

In order to more clearly illustrate technical solutions in embodiments of the present disclosure, accompanying drawings used for describing the embodiments will be briefly introduced below. Apparently, the accompanying drawings in the following description are only some of the embodiments of the present disclosure, and any ordinary skilled person in the art may obtain other accompanying drawings based on these drawings without making any creative work.
FIG. 1 is a structural schematic view of an array substrate according to an embodiment of the present disclosure.
FIG. 2 is a modular schematic view of a pixel unit located at a region A shown in FIG. 2.
FIG. 3 is a circuit diagram of a first pixel unit and a second pixel unit according to an embodiment of the present disclosure.
FIG. 4 is an equivalent circuit diagram of a capacitance-resistance compensation unit according to an embodiment of the present disclosure.
FIG. 5 is a structural schematic view of film layers of the array substrate according to an embodiment of the present disclosure.
FIG. 6 is a schematic view of an RC compensation according to a first embodiment of the present disclosure.
FIG. 7 is a schematic view of an RC compensation according to a second embodiment of the present disclosure.
FIG. 8 is a structural schematic view of a display panel according to an embodiment of the present disclosure.

Reference numerals in the drawings:
array substrate 100; counter substrate 200; display panel 300;
first display region A1; second display region A2; pixel unit P; first pixel unit P1; second pixel unit P2; scan signal line Scan; first scan signal line Scan_1; second scan signal line Scan_2; drive signal line EM; first drive signal line EM_1; second drive signal line EM_2; reset signal line Vint; first reset signal line Vint_1; second reset signal line Vint_2;
capacitance-resistance compensation unit RC; resistance compensation unit R; capacitance compensation unit C;
substrate 10; semiconductor layer 20; gate insulating layer 30; first metal layer 40; interlayer dielectric layer 50; second metal layer 60; passivation layer 70; third metal layer 80; planarization layer 91; anode layer 92; pixel definition layer 93; support layer 94;
first semiconductor sub-wire 21; and second semiconductor sub-wire 22; third semiconductor sub-wire 23; fourth semiconductor sub-wire 24;
first metal sub-wire 41; second metal sub-wire 42; third metal sub-wire 43; eighth metal sub-wire 44; ninth metal sub-wire 45; and tenth metal sub-wire 46;
fourth metal sub-wire 61; and fifth metal sub-wire 62; sixth metal sub-wire 63; seventh metal sub-wire 64; eleventh metal sub-wire 65; twelfth metal sub-wire 66; thirteenth metal sub-wire 67; fourteenth metal sub-wire 68; fifteenth metal sub-wire 69;
sixteenth metal sub-wire 81;
first contact hole H1; second contact hole H2; third contact hole H3 ; fourth contact hole H4; fifth contact hole H5; sixth contact hole H6; seventh contact hole H7; eighth contact hole H8; ninth contact hole H9; tenth contact hole H10; eleventh contact hole H11; twelfth contact hole H12; thirteenth contact hole H13; fourteenth contact hole H14; fifteenth contact hole H15; opening X1.

### DETAILED DESCRIPTIONS

The technical solutions in the embodiments of the present disclosure will be described in detail below by referring to the accompanying drawings of the present disclosure.

In the following description, specific details such as particular system structures, interfaces, techniques, and the like are described for purposes of illustration and not for purposes of limitation, so as to provide thorough understanding of the present disclosure.

The technical solutions in the embodiments of the present disclosure will be described clearly and comprehensively below by referring to the accompanying drawings of the present disclosure. Apparently, the described embodiments are only a part of, not all of, the embodiments of the present disclosure. All other embodiments, which are obtained by any ordinary skilled person in the art based on the embodiments in the present disclosure without making creative work, shall fall within the scope of the present disclosure.

Terms "first", "second", and "third" in the present disclosure are used for descriptive purposes only and are not to indicate or imply relative importance or implicitly specifying the number of technical features. Therefore, a feature defined with "first", "second", "third" may include at least one such feature, either explicitly or implicitly. In the description of the present disclosure, "a plurality of" means at least two, such as two, three, and so on, unless otherwise expressly and specifically limited. All directional indications (such as up, down, left, right, front, rear ......) in the embodiments of the present disclosure are only used to explain a relative positional relationship and movement between components at a particular attitude (the attitude as shown in the accompanying drawings). The directional indication may be changed accordingly when the particular attitude is changed. Furthermore, terms "include" and "have" and any variations thereof are intended to cover non-exclusive inclusion. For example, a process, a method, a system, a product or an apparatus including a series of steps or units is not limited to the listed steps or units, but may further include steps or units that are not listed or steps or units that are inherently included in the process, the method, the system, the product or the apparatus.

Reference to "embodiments" herein means that particular features, structures, or characteristics described in an embodiment may be included in at least one embodiment of the present disclosure. The phrase at various sections in the specification does not necessarily refer to one same embodiment, nor separate or alternative embodiments that are mutually exclusive of other embodiments. Any ordinary skilled person in the art shall understand that, both explicitly and implicitly, the embodiments described herein may be combined with other embodiments.

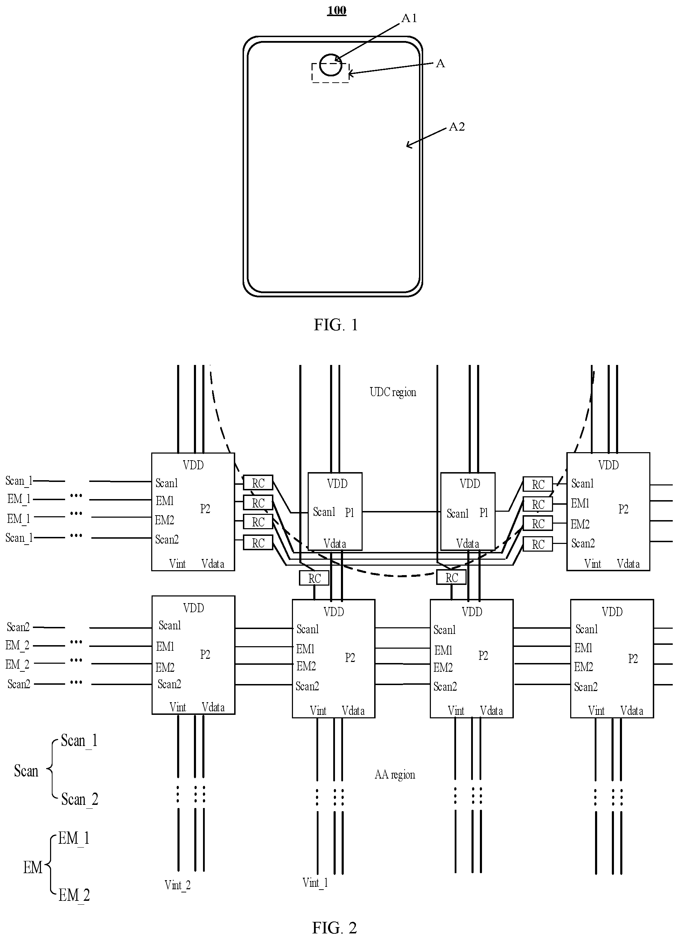

As shown in FIG. 1 and FIG. 2, FIG. 1 is a structural schematic view of an array substrate according to an embodiment of the present disclosure; and FIG. 2 is a modular schematic view of a pixel unit located at a region A shown in FIG. 2.

The present disclosure provides an array substrate 100 may include a first display region A1 and a second display region A2. A light transmittance of the first display region A1 may be greater than a light transmittance of the second display region A2. The array substrate 100 may further include a plurality of pixel units P arranged in an array, scan signal lines Scan and drive signal lines EM connected to a plurality of rows of the plurality of pixel units P, and reset signal lines Vint connected to a plurality of columns of the plurality of pixel units P. The plurality of pixel units P may include a plurality of first pixel units P1 arranged in the first display region A1 and a plurality of second pixel units P2 arranged in the second display region A2. At least a portion of the plurality of first pixel units P1 and at least a portion of the plurality of second pixel units P2 may be arranged in one row and are connected to each other via a first scan signal line Scan_1 and a first drive signal line EM_1. At least a portion of the plurality of first pixel units P1 and at least a portion of the plurality of second pixel units P2 may be arranged in one column and connected to each other via a first reset signal line Vint_1. One of a plurality of rows of the plurality of pixel units P may include only a portion of the plurality of second pixel units P2, and the portion of the plurality of second pixel units P2 in the one row may be connected to each other via a second scan signal line Scan_2 and a second drive signal line EM_2. One of a plurality of columns of the plurality of pixel units P may include only a portion of the plurality of second pixel units P2, and the portion of the plurality of second pixel units P2 in the one column may be connected to each other via a second reset signal line Vint_2.

The first display region A1 may be an under-display camera region (or UDC region), and the second display region A2 may be a normal display region (or AA region). The second display region A2 may surround at least one side of the first display region A1. For example, the second display region A2 may surround a circumference of the first display region A1 or surround a half of the circumference of the first display region A1. Arrangement of the second display region A2 and the first display region A1 may not be limited herein.

However, since the first display region A1 is the UDC region, in order to ensure the light transmittance of the first display region A1 to be large, a pixel density of the UDC region may be smaller than a pixel density of the normal display region. Alternatively, sizes of the pixel units P in the UDC region may be smaller than sizes of the pixel units P in the normal display region. In this way, wires arranged in the UDC region may be reduced. However, Applicant of the present disclosure discovers that a circuti structure in the UDC region is different from a circuti structure in the normal display region, such that n rows of pixels within the UDC region may provide different display effects from pixels located in the rest region.

As shown in FIG. 2, in embodiments of the present disclosure, in order to ensure a display effect of the UDC region, the pixel density of the UDC region may be equal to the pixel density of the normal display region, and sizes of the plurality of first pixel units P1 arranged in the UDC region may be smaller than sizes of the plurality of second pixel units P2 arranged in the normal display region.

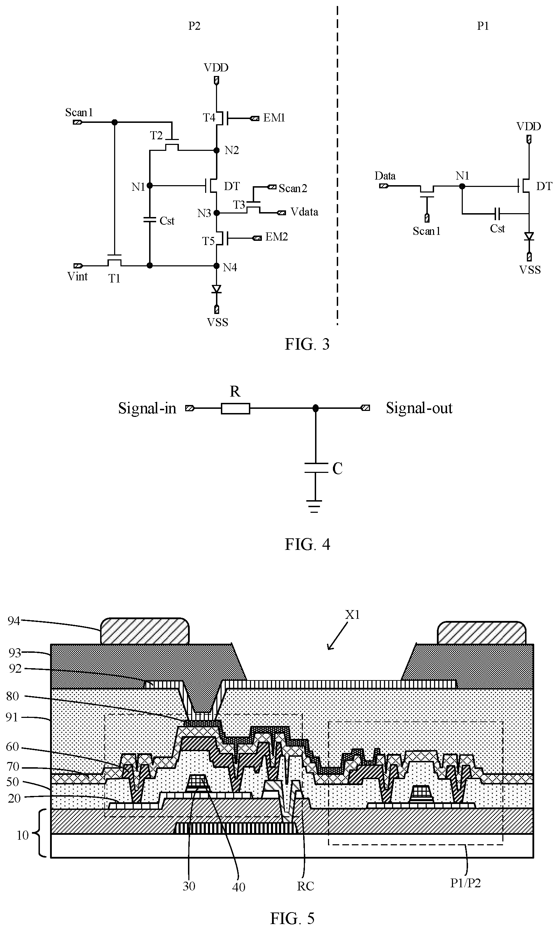

Specifically, as shown in FIG. 3, FIG. 3 is a circuit diagram of the plurality of first pixel units and the plurality of second pixel units according to an embodiment of the present disclosure. In the present embodiment, a 2T1C circuti structure, which has a simple structure, may be arranged in the UDC region; and a circuti structure having a compensation function (such as a 3T1C circuti structure, a 4T2C circuti structure, a 5T2C circuti structure, a 6T1C circuti structure, a 7T1C circuti structure and other circuti structures) may be arranged in the AA region, except for the UDC region. In the present embodiment, the 6T1C circuti structure may be arranged in the AA region.

As shown in FIG. 3, according to a difference in circuti structures between the UDC region and the AA region, the circuti structure of the plurality of first pixel units P1 in the UDC region may be simplified, and therefore, an RC loading difference may be formed between arrangement of the first scan signal line Scan_1 (such as Scan2), the second drive signal line EM_1 (such as EM1&2), and the first reset signal line Vint_1 (such as Vint), and arrangement of the second scan signal line Scan_2, the second drive signal line EM_2, and the second reset signal line Vint_2, such that the n rows of pixels located in the UDC region may have the different display effects from pixels located in the rest region.

To solve the above problem, as shown in FIGS. 2 and 4, FIG. 4 is an equivalent circuit diagram of a capacitance-resistance compensation unit according to an embodiment of the present disclosure. In the present embodiment, a capacitance-resistance compensation unit RC is arranged on each of the first scan signal line Scan_1, the first drive signal line EM_1, and the first reset signal line Vint_1. The capacitance-resistance compensation unit RC may include a resistance compensation unit R and a capacitance compensation unit C. Specifically, the resistance compensation unit R may be connected in series to each of the first scan signal line Scan_1, the first drive signal line EM_1, and the first reset signal line Vint_1. The resistance compensation unit R is configured to compensate for a difference in resistance between n rows of pixel units P within the UDC region (each of the n row of pixel units P includes at least one of the plurality of first pixel units P1 and at least one of the plurality of second pixel units P2) and the other rows of pixel units P (each of the other rows of pixel units P includes only a portion of the plurality of second pixel units P2). A projection of an extension line of the first scan signal line Scan_1 and a projection of an extension line of the first drive signal line EM_1 may have a projection overlapping region. At least a portion of the projection overlapping region forms the capacitance compensation unit C. The first scan signal line Scan_1, the first drive signal line EM_1, and the first reset signal line Vint_1 are all connected in parallel to the capacitance compensation unit C. The capacitance compensation unit C may be configured to compensate for a difference in capacitance between the n rows of pixel units P within the UDC region and the other rows of pixel units P. In this way, a difference in displaying effects between the n rows of pixel units P within the UDC region and the pixel units P in the rest region may be reduced.

In FIG. 4, "Signal-in" denotes a signal input end, and "Signal-out" denotes a signal output end, specific connection therebetween may be determined based on a signal flow direction on each respective signal line where the signal input end and the signal output end are located.

Specifically, in the n rows of pixel units P within the UDC region, the first scan signal line Scan_1 of each of the n rows is connected in series with the resistance compensation unit R and connected in parallel with the capacitance compensation unit C, such that RC compensation may be achieved for the first scan signal line Scan_1 of each of the n rows, and the difference in resistance and the difference in capacitance between the first scan signal line Scan_1 and the second scan signal line Scan_2 may be compensated. In the n rows of pixel units P within the UDC region, the first drive signal line EM_1 of each of the n rows may be connected in series with the resistance compensation unit R and connected in parallel with the capacitance compensation unit C, such that RC compensation may be achieved for the first drive signal line EM_1 of each of the n rows, and the difference in resistance and the difference in capacitance between the first drive signal line EM_1 and the second drive signal line EM_2 may be compensated. In the n rows of pixel units P within the UDC region, the first reset signal line Vint_1 of each column may be connected in series with the resistance compensation unit R and connected in parallel with the capacitance compensation unit C, such that RC compensation may be achieved for the first reset signal line Vint_1 of each column, and the difference in resistance and the difference in capacitance between the first reset signal line Vint_1 and the second reset signal line Vint_2 may be compensated. By performing RC compensation for each of the first scan signal line Scan_1, the first drive signal line EM_1, and the first reset signal line Vint_1 connected to the n rows of pixel units P within the UDC region, electrical properties of the first scan signal line Scan_1, the first drive signal line EM_1, and the first reset signal line Vint_1 may be consistent with electrical properties of the second scan signal line Scan_2, the second drive signal line EM_2, and the second reset signal line Vint_2 connected to rows of pixel units P in the rest region. In this way, the difference in displaying effects between the n rows of pixel units P within the UDC region and the pixel units P in the rest region may be reduced.

In the present embodiment, the resistance compensation unit R and the capacitance compensation unit C may both be arranged in the first display region A1. Specifically, since the circuit structure of the plurality of second pixel units P2 in the second display region A2 is complex and the sizes of the plurality of second pixel units P2 are relatively large, a gap between every two of the plurality of second pixel units P2 may be small. In the present embodiment, both the resistance compensation unit R and the capacitance compensation unit C may be arranged in the first display region A1. In this way, the resistance compensation unit R and the capacitance compensation unit C may not occupy a space in the second display region A2, preparation processes of the resistance compensation unit R and the capacitance compensation unit C may be simplified. The resistance compensation unit R and the capacitance compensation unit C may be disposed at an edge of the first display region A1 near the second display region A2, such that an influence in the light transmittance of the first display region A1 may be optimally reduced.

Alternatively, in the present embodiment, the resistance compensation unit R and the capacitance compensation unit C may both be arranged in the second display region A2. Specifically, when the first display region A1 is the UDC region, the first display region A1 needs to have large light transmittance to satisfy image capturing requirements. Therefore, in order to prevent the resistance compensation unit R and the capacitance compensation unit C from affecting the light transmittance of the first display region A1, the resistance compensation unit R and the capacitance compensation unit C may be arranged in the second display region A2. The resistance compensation unit R and the capacitance compensation unit C may be disposed at an edge of the second display region A2 near the first display region A1, such that preparation processes of the resistance compensation unit R and the capacitance compensation unit C in the second display region A2 may be optimally simplified.

Alternatively, a portion of the resistance compensation unit R may be arranged in the first display region A1, and the rest portion of the resistance compensation unit R may be arranged in the second display region A2. Furthermore, a portion of the capacitance compensation unit C may be arranged in the first display region A1, and the rest portion of the capacitance compensation unit C may be arranged in the second display region A2. Specifically, by reasonably arranging the resistance compensation unit R and the capacitance compensation unit C to be within the first display region A1 and the second display region A2, the light transmittance of the first display region A1 may be ensured, and the preparation processes of the resistance compensation unit R and the capacitance compensation unit C in the second display region A2 may be simplified.

Specifically, as shown in FIG. 5, FIG. 5 is a structural schematic view of film layers of the array substrate according to an embodiment of the present disclosure. In the present embodiment, the array substrate 100 may include a substrate 10, a semiconductor layer 20, a gate insulating layer 30, a first metal layer 40, an interlayer dielectric layer 50, and a second metal layer 60.

Specifically, the semiconductor layer 20 may be disposed on a first surface of the substrate 10. The semiconductor layer 20 may include a first semiconductor layer for forming the plurality of first pixel units P1, a second semiconductor layer for forming the plurality of second pixel units P2, and a semiconductor wire for forming the resistance compensation unit R.

The gate insulating layer 30 may be arranged on a surface of the semiconductor layer 20 away from the substrate 10 and may be configured to isolate the first metal layer 40 from the semiconductor layer 20.

The first metal layer 40 may be arranged on a surface of the gate insulating layer 30 away from the substrate 10. The first metal layer 40 may include a first gate for forming each of the plurality of first pixel units P1, a second gate for forming each of the plurality of second pixel units P2, and a semiconductor wire for forming a portion of the first scan signal line Scan_1 and an extension line of the first scan signal line and for forming a portion of the first drive signal line EM_1 and an extension line of the first drive signal line EM_1.

The interlayer medium layer 50 may be arranged on the first surface of the substrate 10 and may cover the semiconductor layer 20 and the first metal layer 40 to isolate the first metal layer 40, the interlayer medium layer 50, and the second metal layer 60 from each other.

. The second metal layer 60 may be on a surface of the interlayer dielectric layer 50 away from the gate insulating layer 30. The second metal layer 60 may include: a first source and a first drain that are insulated and are configured for form each of the plurality of first pixel units P1; second source and a second drain that are insulated and are configured for form each of the plurality of second pixel units P2; and second metal wires for forming a portion of the first scan signal line Scan_1 and the extension line of the first scan signal line and for forming a portion of the first drive signal line EM_1 and an extension line of the first drive signal line EM_1.

At least a portion of the projection of the extension line of the first scan signal line Scan_1 on the substrate 10 may overlap with at least a portion of the projection of the extension line of the first drive signal line EM_1 on the substrate 10, and the overlap portion may serve as the capacitance compensation unit C.

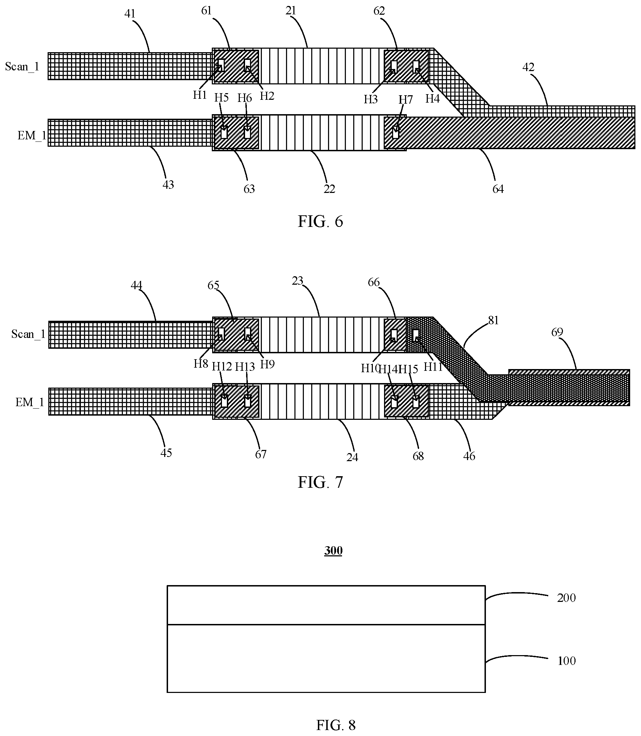

As shown in FIG. 6, FIG. 6 is a schematic view of RC compensation according to a first embodiment of the present disclosure. Specifically, in the first embodiment, the semiconductor wire may include a first semiconductor sub-wire 21 and a second semiconductor sub-wire 22. The first metal wire may include a first metal sub-wire 41 for forming the portion of the first scan signal line Scan_1, a second metal sub-wire 42 for forming the extension line of the portion of the first scan signal line Scan_1, and a third metal sub-wire for forming a portion of the first drive signal line EM_1. The second metal wire may include a fourth metal sub-wire 61 and a fifth metal sub-wire 62 for forming another portion of the first scan signal line Scan_1, a sixth metal sub-wire 63 for forming the extension line of the portion of the first drive signal line EM_1, and a seventh metal sub-wire 64 for forming the extension line of the portion of the first drive signal line EM_1.

The first metal sub-wire 41 may be connected to the fourth metal sub-wire 61 through a first contact hole H1 penetrating the interlayer dielectric layer 50. The fourth metal sub-wire 61 may be connected to the first semiconductor sub-wire 21 through a second contact hole H2. The first semiconductor sub-wire 21 may be connected to the fifth metal sub-wire 62 through a third contact hole H3. The fifth metal sub-wire 62 may be connected to the second metal sub-wire 42 through a fourth contact hole H4. The first semiconductor sub-wire 21 may serve as the resistance compensation unit R of the first scan signal line Scan_1.

The third metal sub-wire 43 may be connected to the sixth metal sub-wire 63 through a fifth contact aperture H5 penetrating the interlayer dielectric layer 50. The sixth metal sub-wire 63 may be connected to the second semiconductor sub-wire 22 through a sixth contact hole H6. The second semiconductor sub-wire 22 may be connected to the second metal sub-wire 64 through a seventh contact hole H7. The second semiconductor sub-wire 22 may serve as the resistance compensation unit R of the first drive signal line EM_1.

A projection of the second metal sub-wire 42 on the substrate 10 may at least partially overlap with a projection of the seventh metal sub-wire 64 on the substrate 10. A projection overlapping region of the projection of the second metal sub-wire 42 and the projection of the seventh metal sub-wire 64 may serve as the capacitance compensation unit C of the first scan signal line Scan_ 1, the first drive signal line EM_1, and/or the first reset signal line Vint_1.

Specifically, FIG. 6 shows RC compensation having transversely extending wires. The resistance compensation unit R may be formed by arranging the first semiconductor sub-wire 21 and the second semiconductor sub-wire 22, and the capacitance compensation unit C may be formed by the projection overlapping region of the projection of the second metal sub-wire 42 and the projection of the seventh metal sub-wire 64. A resistance value of the resistance compensation unit R may be correlated with a size of the first semiconductor sub-wire 21/a size of the second semiconductor sub-wire 22 and a doping concentration thereof. The capacitance compensation unit C may be correlated with an overlapping area of the projection overlapping region of the second metal sub-wire 42 and the seventh metal sub-wire 64 on the substrate 10. Therefore, the resistance value of the resistance compensation unit R may be changed by changing a length and a width of the first semiconductor sub-wire 21/the second semiconductor sub-wire 22 and the doping concentration thereof; and a capacitance value of the capacitance compensation unit C may be changed by changing the overlapping area of the projection overlapping region of the second metal sub-wire 42 and the seventh metal sub-wire 64. In this way, compensation for the rows within the UDC region may be determined according to the actual situation.

Further, in the first embodiment, the resistance compensation unit R of the first scan signal line Scan_1 may be formed by the first semiconductor sub-wire 21, the resistance compensation unit R of the first drive signal line EM_1 may be formed by the second semiconductor sub-wire 22; and the capacitance compensation unit C of the first scan signal line Scan_1 and the first drive signal line EM_1 may be formed by the projection overlapping region of the projection of the second metal sub-wire 42 and the projection of the seventh metal sub-wire 64 EM_1. In this way, an area for arranging wires may be reduced.

As shown in FIG. 5, in the present embodiment, the array substrate 100 may further include a passivation layer 70 and a third metal layer 80.

The passivation layer 70 may be disposed on a surface of the interlayer dielectric layer 50 away from the gate insulating layer 30 and cover the second metal layer 60, so as to isolate the second metal layer 60 and the third metal layer 80 from each other.

The third metal layer 80 may be disposed on a surface of the passivation layer 70 away from the interlayer dielectric layer 50. At least a portion of a projection of the third metal layer 80 on the substrate 10 may overlap with at least a portion of the projection of the extension line of the first scan signal line Scan_1 and/or the extension line of the first drive signal line EM_1 on the substrate 10. A projection overlapping region of the at least the portion of the projection of the third metal layer 80 and the extension line of the first scan signal line Scan_1 and/or the extension line of the first drive signal line EM_1 may serve as the capacitance compensation unit C.

As shown in FIG. 7, FIG. 7 is a schematic view of RC compensation according to a second embodiment of the present disclosure. Specifically, in the second embodiment, the semiconductor wire may include a third semiconductor sub-wire 23 and a fourth semiconductor sub-wire 24. The first metal wire may include: an eighth metal sub-wire 44 for forming a portion of the first scan signal line Scan_1, a ninth metal sub-wire 45 for forming a portion of the first drive signal line EM_1, and a tenth metal sub-wire 46 for forming the extension line of the portion of the first scan signal line Scan_1. The second metal wire may include an eleventh metal sub-wire 65 and a twelfth metal sub-wire 66 for forming a portion of the first scan signal line Scan_1, a thirteenth metal sub-wire 67 for forming a portion of the first drive signal line EM_1, and a fourteenth metal sub-wire 68 and a fifteenth metal sub-wire 69 for forming an extension line of the portion of the first drive signal line EM_1. The third metal layer 80 may include a sixteenth metal sub-wire 81.

The eighth metal sub-wire 44 may be connected to the eleventh metal sub-wire 65 through an eighth contact hole H8 penetrating the interlayer dielectric layer 50. The eleventh metal sub-wire 65 may be connected to the third semiconductor sub-wire 23 through a ninth contact hole H9. The third semiconductor sub-wire 23 may be connected to the twelfth metal sub-wire 66 through a tenth contact hole H10. The twelfth metal sub-wire 66 may be connected to the sixteenth metal sub-wire 81 through an eleventh contact hole H11. The third semiconductor sub-wire 23 may serve as the resistance compensation unit R of the first scan signal line Scan_1.

The ninth metal sub-wire 45 may be connected to the thirteenth metal sub-wire 67 through a twelfth contact hole H12 penetrating the interlayer dielectric layer 50. The thirteenth metal sub-wire 67 may be connected to the fourth semiconductor sub-wire 24 through a thirteenth contact hole H13. The fourth semiconductor sub-wire 24 may be connected to the fourteenth metal sub-wire 68 through a fourteenth contact hole H14. The fourteenth metal sub-wire 68 may be connected to the tenth metal sub-wire 46 through a fifteenth contact hole H15. The fourth semiconductor sub-wire 24 may serve as the resistance compensation unit R of the first drive signal line EM_1.

A projection of the sixteenth metal sub-wire 81 on the substrate 10 may at least partially overlap with a projection of the tenth metal sub-wire 46 on the substrate 10 and/or a projection of the fifteenth metal sub-wire 69 on the substrate 10. A projection overlapping region of the projection of the sixteenth metal sub-wire 81 and the projection of the tenth metal sub-wire 46 and/or the fifteenth metal sub-wire 69 may serve as the capacitance compensation unit C of the first scan signal line Scan_1, the first drive signal line EM_1, and/or the first reset signal line Vint_1.

Specifically, FIG. 7 shows another RC compensation having the transversely extending wires. The resistance compensation unit R may be formed by the third semiconductor sub-wire 23 and the fourth semiconductor sub-wire 24. The capacitance compensation unit C may be formed by the sixteenth metal sub-wire 81 overlapping with the tenth metal sub-wire 46 and/or the fifteenth metal sub-wire 69. The resistance value of the resistance compensation unit R may be correlated to a size of the third semiconductor sub-wire 23/the fourth semiconductor sub-wire 24 and a doping concentration thereof. The capacitance value of the capacitance compensation unit C may be correlated to an overlapping area of the projection overlapping region of the sixteenth metal sub-wire 81 and the tenth metal sub-wire 46 and/or the fifteenth metal sub-wire 69 on the substrate 10. Therefore, the resistance value of the resistance compensation unit R may be changed by changing a length and a width of the third semiconductor sub-wire 23/the fourth semiconductor sub-wire 24 and the doping concentration thereof. The capacitance value of the resistance compensation unit R may be changed by changing the overlapping area of the projection overlapping region of the sixteenth metal sub-wire 81 and the tenth metal sub-wire 46 and/or the fifteenth metal sub-wire 69 on the substrate 10. In this way, compensation for the rows within the UDC region may be determined according to actual situations.

In addition, in the second embodiment, the resistance compensation unit R for the first scan signal line Scan_1 may be formed by the third semiconductor sub-wire 23, the resistance compensation unit R for the first drive signal line EM_1 may be formed by the fourth semiconductor sub-wire 24. The capacitance compensation unit C for the first scan signal line Scan_1 and the first drive signal line EM_1 may be formed by the projection overlapping region of the sixteenth metal sub-wire 81 and the sixteenth metal sub-wire 46 and/or the fifteenth metal sub-wire 69. In this way, an area for arranging wires may be reduced.

Further, in the second embodiment, the fifteenth metal sub-wire 69 may further be connected to a preset electrical potential. Specifically, the preset electrical potential may be a fixed electrical potential. Since the fifteenth metal sub-wire 69 is connected to the preset electrical potential, an anti-interference capability of a capacitor formed by the fifteenth metal sub-wire 69 with the sixteenth metal sub-wire 81 may be improved, and an anti-interference capability of a capacitor formed by the fifteenth metal sub-wire 69 with the tenth metal sub-wire 46 may be improved. In this way, interference between signals may be reduced.

In the above first embodiment and/or the second embodiment, the resistance value of the resistance compensation unit R may be less than or equal to 1 KΩ, and the capacitance value of the capacitance compensation unit C may be less than or equal to 10 pF. Of course, in other embodiments, various display panels may have various resolutions, the resistance value of the resistance compensation unit R and the capacitance value of the capacitance compensation unit C may be determined according to the actual situations.

Specifically, the above first embodiment and/or the second embodiment may be examples only, and details thereof may be designed according to actual needs.

As shown in FIG. 5, in the present embodiment, the array substrate 100 may further include a planarization layer 91, an anode layer 92, a pixel definition layer 93, and a support layer 94.

The planarization layer 91 may be disposed on a side of the passivation layer 70 away from the interlayer medium layer 50 and cover the third metal layer 80. The anode layer 92 may be disposed on a side of the planarization layer 91 away from the passivation layer 70. The anode layer 92 may be connected to the source/the drain via the contact hole. The pixel definition layer 93 may be disposed on the side of the planarization layer 91 away from the passivation layer 70. The pixel definition layer 93 may have an opening X1 for receiving the light emitting device, and at least a portion of the anode layer 92 may be exposed from the opening X1. The support layer 94 may be arranged on the side of the pixel definition layer 93 away from the planarization layer 91.

Specifically, the present disclosure provides the array substrate 100. The resistance compensation unit R may be connected in series to each of the first scan signal line Scan_1, the first drive signal line EM_1, and the first reset signal line Vint_1. The resistance compensation unit R may be configured to compensate for the difference in resistance between the n rows of pixel units P within the UDC region and the other rows of pixel units P. The projection overlapping region is formed by the projection of the extension line of the first scan signal line Scan_1 and the projection of the extension line of the first drive signal line EM_1. At least a portion of the projection overlapping region may form the capacitance compensation unit C. Each of the first scan signal line Scan_1, the first drive signal line EM_1, and the first reset signal line Vint_1 may be connected in parallel to the capacitance compensation unit C. The capacitance compensation unit C may be configured to compensate for the difference in capacitance between the n rows of pixel units P within the UDC region and the other rows of pixel units P. In this way, differences in the displaying effects between the n rows of pixel units P within the UDC region and pixel units in the rest region may be reduced.

As shown in FIG. 8, FIG. 8 is a structural schematic view of the display panel according to an embodiment of the present disclosure. The present disclosure further provides a display panel 300 including the array substrate 100 and a counter substrate 200. The array substrate 100 may be the array substrate 100 provided in any of the above embodiments; and the counter substrate may be arranged on a side of the array substrate 100. The counter substrate 200 may serve as an encapsulation cover for the display panel 300 to prevent water steams, dust, and the like from entering the display panel 300 and may provide certain rigidity. Further, the counter substrate 200 may further serve as a color film substrate for the display panel 300.

The above is only an implementation of the present disclosure, and is not intended to limit the scope of the present disclosure. Any equivalent structure or equivalent process transformation performed based on the contents of the specification and the accompanying drawings of the present disclosure, applied directly or indirectly in other related technical fields, shall be equivalently included in the scope of the present disclosure.

## Claims

1. An array substrate, comprising: a plurality of pixel units arranged in an array, a plurality of scan signal lines and a plurality of drive signal lines connecting to a plurality of rows of the plurality of pixel units, and a plurality of reset signal lines connecting a plurality of columns of the plurality of pixel units;
wherein, the plurality of pixel units comprise a plurality of first pixel units arranged in a first display region and a plurality of second pixel units arranged in a second display region; at least a portion of the plurality of first pixel units and at least a portion of the plurality of second pixel units are arranged in one row and connected to each other via a respective one of the plurality of first scan signal lines and a respective one of the plurality of first drive signal lines; at least part of the plurality of first pixel units and at least part of the plurality of second pixel units are arranged in one column and are connected to each other via a respective one of the plurality of first reset signal lines; a light transmittance of the first display region is greater than that of the second display region;
wherein, a resistance compensation unit is connected in series to each of the respective first scan signal line, the respective first drive signal line, and the respective first reset signal line; a projection overlapping region is formed by a projection of an extension line of the respective first scan signal line overlapping with a projection of an extension line of the respective first drive signal line; at least a portion of the projection overlapping region forms a capacitance compensation unit; each of the respective first scan signal line, the respective first drive signal line, and the respective first reset signal line is connected in parallel to the capacitance compensation unit.

2. The array substrate according to claim 1, wherein, the array substrate comprises:
a substrate;
a semiconductor layer, disposed on a first surface of the substrate, wherein the semiconductor layer comprises a first semiconductor layer for forming the plurality of first pixel units, a second semiconductor layer for forming the plurality of second pixel units, and semiconductor wires for forming the resistance compensation unit;
a gate insulating layer, disposed at a surface of the semiconductor layer away from the substrate;
a first metal layer, disposed on a surface of the gate insulating layer away from the substrate; wherein the first metal layer comprises: first gates for forming the plurality of first pixel units; second gates for forming the plurality of second pixel units; and a first metal wire for forming a portion of the respective first scan signal line and the extension line of the respective first scan signal line and forming a portion of the respective first drive signal line and the extension line of the respective first drive signal line;
an interlayer dielectric layer, disposed on the first surface of the substrate and covering the semiconductor layer and the first metal layer;
a second metal layer, disposed on a surface of the interlayer dielectric layer away from the gate insulating layer and comprising: a first source and a first drain that are insulated and are for forming each of the plurality of first pixel units; a second source and a second drain that are insulated and are for forming each of the plurality of second pixel units; a second metal wire for forming a portion of the respective first scan signal line and the extension line of the respective first scan signal line and forming a portion of the respective first drive signal line and the extension line of the respective first drive signal line;
wherein, at least a portion of a projection of the extension line of the respective first scan signal line on the substrate and at least a portion of a projection of the extension line of the respective first drive signal line on the substrate overlap with each other to serve as the capacitance compensation unit.

3. The array substrate according to claim 2, wherein, the semiconductor wire comprises a first semiconductor sub-wire and a second semiconductor sub-wire;
the first metal wire comprises a first metal sub-wire for forming the portion of the first scan signal line, a second metal sub-wire for forming a portion of the extension line of the first scan signal line, and a third metal sub-wire for forming a portion of the first drive signal line metal wire;
the second metal wire comprises a fourth metal sub-wire and a fifth metal sub-wire for forming a portion of the first scan signal line, a sixth metal sub-wire for forming a portion of the extension line of the first drive signal line, and a seventh metal sub-wire for forming a portion of the extension line of the first drive signal line;
the first metal sub-wire is connected to the fourth metal sub-wire through a first contact hole penetrating the interlayer dielectric layer; the fourth metal sub-wire is connected to the first semiconductor sub-wire through a second contact hole; the first semiconductor sub-wire is connected to the fifth metal sub-wire through a third contact hole; the fifth metal sub-wire is connected to the second metal sub-wire through a fourth contact hole; the first semiconductor sub-wire serves as the resistance compensation unit on the first scan signal line;
the third metal sub-wire is connected to the sixth metal sub-wire through a fifth contact hole penetrating the interlayer dielectric layer, the sixth metal sub-wire is connected to the second semiconductor sub-wire through a sixth contact hole, and the second semiconductor sub-wire is connected to the seventh metal sub-wire through a seventh contact hole; the second semiconductor sub-wire serves as the resistance compensation unit on the first drive signal line;
a projection of the second metal sub-wire on the substrate at least partially overlaps with a projection of the seventh metal sub-wire on the substrate; a projection overlapping region of the projection of the second metal sub-wire and the projection of the seventh metal sub-wire serves as the capacitance compensation unit on the first scan signal line, the first drive signal line, and/or the first reset signal line.

4. The array substrate according to claim 2, wherein, the array substrate further comprises:
a passivation layer, disposed on a surface of the interlayer dielectric layer away from the gate insulating layer and covering the second metal layer;
a third metal layer, disposed on a surface of the passivation layer away from the interlayer dielectric layer, wherein at least a portion of a projection of the third metal layer on the substrate overlaps with at least a portion of the extension line of the first scan signal line and/or a projection of the extension line of the first drive signal line on the substrate; at least a portion of a projection overlapping region of the projection of the third metal layer on the substrate overlaps and the portion of the extension line of the first scan signal line and/or the projection of the extension line of the first drive signal line on the substrate serves as the capacitance compensation unit.

5. The array substrate according to claim 4, wherein, the semiconductor wire comprises a third semiconductor sub-wire and a fourth semiconductor sub-wire;
the first metal wire comprises: an eighth metal sub-wire for forming a portion of the first scan signal line, a ninth metal sub-wire for forming a portion of the first drive signal line, and a tenth metal sub-wire for forming a portion of the extension line of the first scan signal line;
the second metal wire comprises: an eleventh metal sub-wire and a twelfth metal sub-wire for forming a portion of the first scan signal line, a thirteenth metal sub-wire for forming a portion of the first drive signal line, and a fourteenth metal sub-wire and a fifteenth metal sub-wire for forming a portion of the extension line of the first drive signal line;
the third metal layer comprises a sixteenth metal sub-wire;
the eighth metal sub-wire is connected to the eleventh metal sub-wire through an eighth contact hole penetrating the interlayer dielectric layer, the eleventh metal sub-wire is connected to the third semiconductor sub-wire through a ninth contact hole, the third semiconductor sub-wire is connected to the twelfth metal sub-wire through a tenth contact hole, the twelfth metal sub-wire is connected to the sixteenth metal sub-wire through an eleventh contact hole; the third semiconductor sub-wire serves as the resistance compensation unit on the first scan signal line;
the ninth metal sub-wire is connected to the thirteenth metal sub-wire through a twelfth contact hole penetrating the interlayer dielectric layer, the thirteenth metal sub-wire is connected to the fourth semiconductor sub-wire through a thirteenth contact hole, and the fourth semiconductor sub-wire is connected to the fourth semiconductor sub-wire through a fourteenth contact hole, the fourteenth metal sub-wire is connected to the tenth metal sub-wire through a fifteenth contact hole, the fourth semiconductor sub-wire serves as the resistance compensation unit on the first drive signal line;
a projection of the sixteenth metal sub-wire on the substrate at least partially overlaps with a projection of the tenth metal sub-wire on the substrate and/or a projection of the fifteenth metal sub-wire on the substrate; a projection overlapping region between the projection of the sixteenth metal sub-wire and the projection of the tenth metal sub-wire and/or the projection of the fifteenth metal sub-wire serves as the capacitance compensation unit on the first scan signal line, the first drive signal line and/or the first reset signal line.

6. The array substrate according to claim 5, wherein, the fifteenth metal sub-wire is further connected to a preset electrical potential.

7. The array substrate according to claim 4, wherein, a resistance value of the resistance compensation unit is correlated to sizes of the semiconductor wires and doping concentrations of the semiconductor wires;
the capacitance compensation unit is correlated to an overlapping area of the projection overlapping region of the projection of the extension line of the first scan signal line and the projection of the extension line of the first drive signal line on the substrate;
the resistance value of the resistance compensation unit is less than or equal to 1 KΩ; the capacitance value of the capacitance compensation unit is less than or equal to 10pF.

8. The array substrate according to claim 1, wherein, a pixel density of the plurality of first pixel units within the first display region is the same as a pixel density of the plurality of second pixel units within the second display region, and a size of each of the plurality of first pixel units is smaller than a size of each of the plurality of second pixel units.

9. The array substrate according to claim 1, wherein the resistance compensation unit and the capacitance compensation unit are both disposed in the first display region; or
the resistance compensation unit and the capacitance compensation unit are both disposed in the second display region; or
a portion of the resistance compensation unit is disposed in the first display region, and another portion of the resistance compensation unit is disposed in the second display region; and a portion of the capacitance compensation unit is disposed in the first display region and another portion of the capacitance compensation unit is disposed in the second display region.

10. A display panel, comprising:
the array substrate according to any one of the claims 1-9; and
a counter substrate, disposed at a side of the array substrate.
